(19) Europäisches Patentamt
European Patent Office
Office européen des brevets

(11) **EP 0 670 069 B1**

(12) **FASCICULE DE BREVET EUROPEEN**

(45) Date de publication et mention
de la délivrance du brevet:
**26.09.2001 Bulletin 2001/39**

(51) Int Cl.[7]: **G06F 17/50**, G06F 9/44

(86) Numéro de dépôt international:
**PCT/FR94/01089**

(21) Numéro de dépôt: **94927697.6**

(22) Date de dépôt: **19.09.1994**

(87) Numéro de publication internationale:
**WO 95/08154 (23.03.1995 Gazette 1995/13)**

(54) **PROCEDE DE DEMONSTRATION AUTOMATIQUE**

VERFAHREN ZUM AUTOMATISCHEN BEWEISEN

AUTOMATIC PROVING METHOD

(84) Etats contractants désignés:
**AT DE FR GB IT NL**

(30) Priorité: **17.09.1993 FR 9311080**

(43) Date de publication de la demande:
**06.09.1995 Bulletin 1995/36**

(73) Titulaire: **BULL S.A.**
**78430 Louveciennes (FR)**

(72) Inventeur: **GOUBAULT, Jean**
**F-75015 Paris (FR)**

(74) Mandataire: **Denis, Hervé et al**
**BULL S.A.,**
**PC LV-58D20**
**68 route de Versailles**
**78434 Louveciennes Cedex (FR)**

(56) Documents cités:
**EP-A- 0 351 842**

- **PROCEEDINGS OF THE 11TH IFIP WG10.2
  INTERNATIONAL CONFERENCE ON
  COMPUTER HARDWARE DESCRIPTION
  LANGUAGES AND THEIR APPLICATIONS, 26
  Avril 1993, OTTAWA ONTARIO CANADA pages
  45 - 62 SCHNEIDER ET AL 'hardware verification
  using first order bdds'**
- **GWAI-92 : ADVANCE IN ARTIFICIAL
  INTELLIGENCE 16TH GERMAN CONFERENCE
  ON ARTIFICIAL INTELLIGENCE PROCEEDINGS,
  31 Août 1992, BONN ALLEMAGNE pages 67 - 76
  POSEGGA ET AL 'TOWARDS FIRST-ORDER
  DEDUCTION BASED ON SHANNON GRAPHS'**

## Description

L'invention est relative à un procédé de démonstration automatique, dont la tâche essentielle est de montrer que l'on peut trouver, à partir d'un résultat souhaité, une solution formelle pour atteindre ce résultat.

Aujourd'hui, la complexité croissante des produits industriels posent de nombreux problèmes tant dans leur conception, leur réalisation que leur exploitation. Pour créer de tels produits, l'être humain met en oeuvre son imagination dans une succession de phases jusqu'à la mise au point définitive de ces produits. Certaines de ces phases sont couramment assistées par des machines telles que des machines outil, des logiciels de conception assistés par ordinateur, cette liste n'étant pas exhaustive.

L'intelligence dont fait preuve l'être humain pour mener à bien la succession de ces différentes phases se base sur son raisonnement. Or le passage d'une étape d'un raisonnement à la suivante, aussi rigoureux soit-il, possède souvent, pour ne pas dire toujours, une part de sous-entendu résultant d'un cheminement intuitif inhérent à la structure de la pensée humaine. Cela fait sa force en ce qu'elle lui permet d'atteindre plus rapidement ses objectifs en négligeant les évidences couramment admises.

Cependant, en court-circuitant les processus fastidieux de raisonnement rigoureux, un appel trop fréquent à l'intuition est source d'erreurs.

Ces erreurs peuvent se traduire par des défaillances de fonctionnement du produit réalisé, défaillances d'autant plus difficiles à détecter, et donc à éliminer, qu' elles sont rares et dispersées.

La spécification formelle d'un système est ce qui permettra d'ériger ce système par simple exécution. Celle-ci consiste à spécifier le système informatique dans un langage qui, s'il ressemble à un langage de programmation, n'a pas néanmoins pour but de calculer mais de décrire un système. Ce langage est muni d'une sémantique mathématique qui définit précisément le sens de toutes les constructions du langage. Ainsi, toute spécification dans ce langage aura -telle une signification précise sous forme d'axiomes mathématiques. Cette liste d'axiomes est représentable et traitable en machine. De plus, les propriétés que nous désirons vérifier seront elles aussi exprimables sous forme de théorèmes mathématiques, et traitables par des outils informatiques de démonstration de théorèmes, qu'ils soient automatiques ou semi-automatiques.

Plutôt que de représenter les formules mathématiques dans la mémoire d'un ordinateur pour traitement il serait envisageable de les laisser démontrer par des êtres humains. Ceci serait néanmoins long, coûteux et de plus n'évite pas les erreurs de raisonnement fréquentes chez l'être humain. C'est pourquoi des outils informatiques de démonstration de théorèmes ont été conçus. Les outils semi-automatiques organisent pour la plupart les axiomes décrivant le langage et les spécifications, ainsi que les propositions à démontrer sur le système, en une base de données sur laquelle un utilisateur humain peut agir par l'intermédiaire d'opérations de déductions bien définies et garanties correctes. Ceci interdit les erreurs humaines, mais ralentit énormément la vérification du système, puisque l'opérateur humain doit prouver que son système est correct en indiquant à l'outil de preuves non seulement les raisons, sous forme des principes de démonstration ou axiomes à utiliser, pour lesquels il le pense correct, mais aussi tous les détails fastidieux de manipulations de symboles, qui sont aussi des axiomes, souvent perçus comme évidents par un être humain.

Un démonstrateur automatique a alors pour charge, à l'intérieur d'un outil de preuves semi-automatiques, d'aider à démontrer ces évidences, et au besoin de démontrer les parties même moins évidentes. Ceci fournit un confort appréciable pour l'opérateur humain, assisté de la machine qui travaille en parallèle avec lui ; ceci résulte en une démonstration plus rapide, mais tout aussi rigoureuse, des théorèmes représentant les propriétés de certification de bon fonctionnement des systèmes informatiques spécifiés.

Les techniques de démonstration automatique connues, suivant l'état de la technique, (résolution, tableaux sémantiques, méthode des connexions/matings,...etc.) n'offrent qu'une aide relative, notamment à cause du fait qu'elles peuvent passer des temps disproportionnés sur des problèmes de difficultés perçues très similaires. La technique de démonstration automatique identifie la notion de difficulté à une taille d'arbre de recherches de preuves, identifiées par sa profondeur et sa largeur. Si la profondeur est une caractéristique du théorème à démontrer, la largeur est caractéristique du théorème et de la procédure de recherche de preuves.

Un article de Posegga et al. "Towards First-order Deduction Based on Shannon Graphs" publié aux pages 67 à 76 du document "GWAI-92: Advances in Artificial Intelligence" suite à la seizième conférence allemande de 1992 à Bonn, propose de représenter une formule à démontrer, sous forme de graphe de Shannon ou de diagramme de décision binaire BDD. Une procédure de preuve consiste ici à rechercher une substitution qui, appliquée à un graphe de Shannon déterminé, amène à clore le graphe au sens de la preuve. L'arbre associé est parcouru par profondeur d'abord itérative de façon à parcourir systématiquement toutes les branches des solutions possibles. Une mise en oeuvre de cette méthode a été faite en logique propositionnelle. Cependant, la taille imprévisible d'un tel arbre de recherche en logique du premier ordre, imposée par des amplifications du BDD de départ, risque d'amener à une explosion de la taille mémoire nécessaire et du temps d'exécution.

Un article de Schneider et al. "Hardware-Verification using First Order BDDs" publié au pages 45 à 62 du document "Computer Hardware Description Languages and their applications" suite à la conférence internationale d'avril 1993 à Ottawa, propose de réduire un BDD amplifié à une constante au moyen d'une substitution. Cependant, cet article ne décrit pas comment trouver concrètement cette substitution. Or, chaque amplification du BDD de départ augmente le nombre de substitutions possibles et par conséquent la largeur d'un éventuel arbre de recherche. Le résultat d'une procédure par devinette, resterait aléatoire.

La procédure de l'invention minimise cette largeur d'arbre étape par étape, et en même temps explore l'arbre engendré suivant une stratégie, dite de parcours par gain maximal d'information d'abord, dont le but est de prouver et de trouver la preuve le plus vite possible.

L'objet de l'invention est un procédé de démonstration automatique de théorèmes en logique classique du premier ordre permettant d'accroître la confiance accordée dans le développement de produits par le formalisme des solutions contrôlées par une machine.

Ce procédé est particulièrement intéressant en informatique pour vérifier des protocoles de communication en architecture multiprocesseurs, pour établir des spécifications à partir de programmes ou dans un processus de raffinement d'une spécification formelle pour établir un programme.

Plus précisément, le procédé de démonstration automatique de propositions décrit des systèmes physiques, en logique du premier ordre. Il est mis en oeuvre à l'aide d'un ordinateur dans la mémoire duquel une proposition à démontrer est représentée par au moins un diagramme de décision binaire BDD. Le procédé est caractérisé en ce qu'il cherche à réduire le BDD à une constante V, symbolisant le vrai, par au moins une substitution en construisant et en explorant un arbre de recherche des substitutions possibles, dont chaque noeud est associé à un BDD résultant d'une substitution possible.

Selon un autre objet de l'invention, l'arbre de recherche est construit en minimisant son facteur de branchement, et exploré en maximisant le gain d'information, calculé à chaque noeud de l'arbre de recherche.

Selon encore un autre objet de l'invention, le gain d'information est calculé à chaque noeud associé à un BDD Phi, comme la différence entre la quantité d'information QI(Phi) au noeud et la quantité d'information à la racine de l'arbre de recherche, de laquelle on retranche la somme des logarithmes des nombres de successeurs immédiats des noeuds sur la branche entre la racine et le noeud considéré, à l'inclusion de la racine et à l'exclusion du noeud considéré, où QI(Phi) = bF log( bF / (bF+bV)), bF étant le nombre de branches fausses du BDD Phi et bV étant le nombre de branches vraies du BDD Phi.

D'autres caractéristiques et avantages apparaîtront à la lecture de la description qui suit, en référence aux figures où,

- la figure 1 représente le diagramme de décision binaire BDD d'un exemple de formule simple,

- la figure 2 représente un exemple possible de stockage en mémoire d'ordinateur du diagramme de la figure 1,

- la figure 3 représente un autre exemple possible de mémorisation d'un diagramme de décision binaire,

- la figure 4 représente le diagramme de décision binaire BDD de l'exemple de la figure 1 avec une copie suplémentaire de la formule de départ.

Les annexes 1 à 9 décrivent les fonctions, à appel récursif, mises en oeuvre au moyen d'un ordinateur pour construire le graphe de décision binaire ci-après nommé BDD d'une formule propositionnelle Phi sous forme prénexe. Une formule est sous forme prénexe lorsque les quantificateurs de ses variables sont situés en tête de la formule.

Nous expliquons maintenant chacune des fonctions des annexes 1 à 9 à l'aide de l'exemple simple d'une formule propositionnelle Phiex:

$$P(a) \text{ ou } P(b) \Rightarrow P(x).$$

Le traitement de formules plus complexes est exécuté de manière identique, mais il est préférable d'en laisser le soin à l'ordinateur.

Chacun des prédicats P(a),P(b),P(x) constitue une formule atomique xi de la formule Phiex. La construction d'un BDD utilise la remarque de Claude Shannon qui dit que pour toute variable propositionnelle, et en particulier pour formule atomique xi, ci-après nommée atome, une formule propositionnelle Phi est représentable sous la forme:

$$(xi \Rightarrow Phi+) \text{ et } (\neg xi \Rightarrow Phi-),$$

où ¬xi symbolise la négation logique de l'atome xi et où l'atome xi n'apparaît ni dans Phi+, ni dans Phi-. Pour deux constantes V et F représentant respectivement le vrai et le faux, il suffit en effet de choisir pour Phi+, la formule Phi où V est substitué à l'atome xi et pour Phi-, la formule Phi où F est substitué à l'atome xi.

Le BDD d'une formule Phi, ci-après nommé Phi, est alors une donnée, au sens informatique du terme, dont le type est défini par trois valeurs possibles, la valeur V, la valeur F ou la valeur du choix d'un atome xi, du BDD de la formule Phi- et du BDD de la formule Phi+, ci-après nommés respectivement Phi- et Phi+.

L'annexe 1 décrit la fonction FaitBDD comme une fonction de trois paramètres, un atome xi, un BDD Phi- et un BDD Phi+. Le résultat d'une fonction est donné par le symbole :=. Si les deux BDD Phi- et Phi+ sont égaux, la fonction retourne le BDD Phi+, sinon elle retourne le résultat de l'appel à la fonction Choix(xi,Phi-,Phi+). En effet, si Phi- et Phi+ sont égaux, cela signifie que la valeur du BDD Phi est indépendante de l'atome xi, et qu'il a donc même valeur que le BDD Phi+.

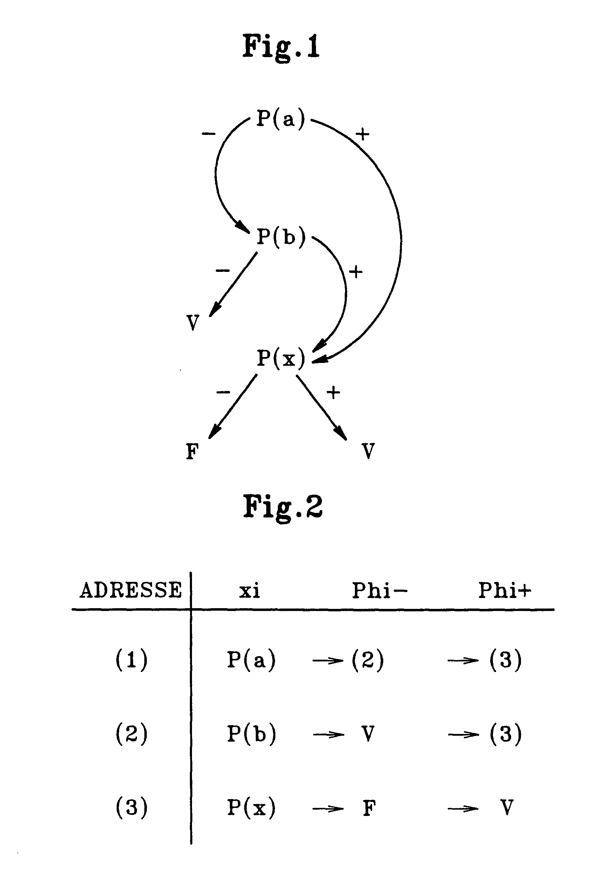

La fonction Choix d'un atome A, d'un BDD Phi1 et d'un BDD Phi2 représente la tête d'un BDD constitué de l'atome A et de deux branches constituées des BDD Phi1 et Phi2. Le résultat de cette fonction est représentable en mémoire d'ordinateur, par exemple, sous forme d'une ligne de tableau à trois champs comme le montre la figure 2.

La fonction de l'annexe 2 réalise le fait que la négation de V est F et réciproquement et le fait que la négation de ((xi⇒Phi+)et(¬xi⇒Phi-)) est ((xi⇒¬ Phi+) et (¬xi⇒¬Phi-)).

La fonction de l'annexe 3 réalise le fait que la conjonction d'un BDD Phi et d'un BDD Phi' est F si l'un des BDD est F, l'autre BDD si l'un des BDD est V. Si Phi=Choix(xi,Phi-,Phi+) et Phi'=Choix(xi',Phi'-,Phi'+), lorsque xi=xi', on remarque que:

((xi⇒Phi+) et (¬xi⇒Phi-))et((xi⇒Phi'+) et (¬xi⇒Phi'-)) est logiquement équivalent à:
((xi⇒Phi+etPhi'+) et (¬xi⇒Phi-etPhi'-)), ce qui donne la dernière ligne de l'annexe 3.

Lorsque xi précède xi' dans l'ordre défini sur les atomes, cela signifie que xi n'apparaît pas dans Phi', ((xi⇒Phi') et (¬xi⇒Phi')) est logiquement équivalent à Phi'. Alors:

((xi⇒Phi+) et (¬xi⇒Phi-))et((xi⇒Phi') et (¬xi⇒Phi')) est logiquement équivalent à:
((xi⇒Phi+etPhi') et (¬xi⇒Phi-etPhi')). Cette remarque reste valable en remplaçant xi par xi' et Phi par Phi', ce qui donne les autres lignes de l'annexe 3.

La fonction de l'annexe 4 réalise le fait que la disjonction d'un BDD Phi et d'un BDD Phi' est V si l'un des BDD est V, l'autre BDD si l'un des BDD est F. Si Phi=Choix(xi,Phi-,Phi+) et Phi'=Choix(xi',Phi'-,Phi'+), lorsque xi=xi', on remarque que:

((xi⇒Phi+) et (¬xi⇒Phi-))ou((xi⇒Phi'+) et (¬xi⇒Phi'-)) est logiquement équivalent à:
((xi⇒Phi+ouPhi'+) et (¬xi⇒Phi-ouPhi'-)), ce qui donne la dernière ligne de l'annexe 4.

Lorsque xi précède xi' dans l'ordre défini sur les atomes, cela signifie que xi n'apparaît pas dans Phi', ((xi⇒Phi') et (¬xi⇒Phi')) est logiquement équivalent à Phi'. Alors:

((xi⇒Phi+) et (¬xi⇒Phi-))ou((xi⇒Phi') et (¬xi⇒Phi')) est logiquement équivalent à:
((xi⇒Phi+ouPhi') et (¬xi⇒Phi-ouPhi')). Cette remarque reste valable en remplaçant xi par xi' et Phi par Phi', ce qui donne les autres lignes de l'annexe 4.

A titre d'exemple de compréhension, appliquons la fonction FaitBDD de l'annexe 1 à la formule Phiex. La construction du BDD est exécutée suivant l'ordre de lecture de la formule Phiex, la première sous formule rencontrée est:

P(a) ou P(b).
Phia := FaitBDD(P(a),Phia-,Phia+), le test d'égalité sur Phia- et Phia+ nécessite de calculer
Phia- := BDDou(F,Phib) et Phia+ := BDDou(V,Phib). Suivant l'annexe 4, Phia- := Phib, avec Phib=Choix(P(b),F, V), et Phia+ := V. Phia- et Phia+ étant différents,
Phia := Choix(P(a),Phib,V).

Le signe suivant de la formule Phiex est l'implication logique qui est traduite par

Phiex := BDDou ( BDDneg(Phia), Phix) avec Phix=Choix(P(x),F,V)
Suivant l'annexe 2,

BDDneg(Phia) := Choix (P(a), BDDneg(Phib), F)
BDDneg(Phib) := Choix (P(b),V, F)

Suivant l'annexe 4, xi=P(a) précède, suivant l'ordre de lecture, xi'=P(x). Phiex

:= FaitBDD (P(a), BDDou(BDDneg(Phib),Phix), BDDou(F,Phix)).
BDDou(BDDneg(Phib),Phix) :=FaitBDD(P(b), BDDou(V,Phix), BDDou(F,Phix)) :=FaitBDD(P(b),V, Phix). Finalement,
Phiex :=Choix ( P(a),Choix(P(b),V,Phix),Phix ).

La représentation en mémoire d'ordinateur de Phiex est schématisé par le tableau de la figure 2 et symbolisé par le dessin de la figure 1.

Suivant l'annexe 5, la fonction RempF(Phi,xi') remplace l'atome xi' par F dans Phi. Si xi' n'apparaît pas dans Phi, le résultat est Phi qui reste inchangé. Si l'atome xi' apparaît dans Phi. Soit il apparaît à la racine de Phi et alors, remplacer l'atome xi' par F revient à prendre Phi-. Soit l'atome xi à la racine de Phi précède l'atome xi' suivant l'ordre défini sur les atomes et alors, remplacer l'atome xi' par F dans Phi revient à remplacer l'atome xi' par F dans Phi- et dans Phi+.

Suivant l'annexe 6, la fonction RempV(Phi,xi') remplace l'atome xi' par V dans Phi. Si xi' apparaît pas dans Phi, le résultat est Phi qui reste inchangé. Si l'atome xi' apparaît dans Phi. Soit il apparaît à la racine de Phi et alors, remplacer l'atome xi' par V revient à prendre Phi+. Soit l'atome xi à la racine de Phi précède l'atome xi' suivant l'ordre défini sur les atomes et alors, remplacer l'atome xi' par V dans Phi revient à remplacer l'atome xi' par V dans Phi- et dans Phi+.

L'annexe 7 décrit la fonction RéduitBDD(Phi,xi,xi') qui permet de tester si l'équivalence logique de deux formules atomiques xi et xi' réduit Phi à V. La fonction RéduitBDD laisse inchangé un BDD réduit à V ou à F. Phi- et Phi+ sont respectivement la branche négative et la branche positive d'un BDD Phi, différent de V ou F, avec êta comme atome à la racine du BDD. Si l'atome êta précède l'atome xi, suivant l'ordre défini sur les atomes, le BDD Phi est reconstruit à l'aide de la fonction FaitBDD de l'annexe 1avec l'atome êta conservé à sa racine et ayant pour branches Phi- et Phi+, celles résultant de l'exécution récursive de la fonction RéduitBDD pour chacune des branches Phi- et Phi+ avec les mêmes atomes xi et xi'. Si l'atome êta est l'atome xi, le BDD Phi est reconstruit à l'aide de la fonction FaitBDD de l'annexe 1avec l'atome êta, égal à l'atome xi, conservé à sa racine et ayant pour nouvelles branches Phi- et Phi+, celles résultant de l'exécution récursive des fonctions des annexes 5 et 6. C'est à dire que l'atome xi', équivalent à l'atome xi, est remplacé par F dans la branche Phi- de Phi qui interprète l'atome xi comme remplacé par F, et que l'atome xi' est remplacé par V dans la branche Phi+ de Phi qui interprète l'atome xi comme remplacé par V. Si l'atome êta succède à l'atome xi, suivant l'ordre défini sur les atomes, le BDD est reconstruit à l'aide de la fonction FaitBDD de l'annexe 1 en plaçant l'atome xi à la racine et en prenant pour branches Phi-, le BDD Phi où l'atome xi' est remplacé par F par l'exécution récursive de la fonction de l'annexe 5, Phi+ le BDD Phi où l'atome xi' est remplacé par V. Ce qui donne une interprétation équivalente des atomes xi et xi'.

L'annexe 9 décrit la fonction RéordBDD(Phi,vars) qui réordonne un BDD Phi suivant l'ordre des atomes d'une liste vars d'atomes. Cette fonction est particulièrement utile pour combiner deux BDD Phi et Phi', dont les atomes obéissent à des ordres différents. La fonction laisse inchangé un BDD Phi égal à V ou à F. Un BDD Phi différent de F ou de V possède un atome A à sa racine et deux branches Phi- et Phi+. Si l'atome A est le premier atome de la liste vars, la liste vars s'écrit encore A::reste où reste est la liste qui contient les atomes succédant à l'atome A. Le BDD est reconstruit par la fonction de l'annexe 1 avec l'atome A à sa racine et pour branches Phi- et Phi+, celles résultant de l'exécution récursive de la fonction RéordBDD avec pour nouvelle liste vars la liste reste, respectivement aux branches Phi- et Phi+ du BDD Phi. Par contre, si le premier atome de la liste vars est un atome A' différent de l'atome A, la liste vars s'écrit encore A'::reste où reste est la liste des atomes succédant à l'atome A'. Le BDD est reconstruit par la fonction de l'annexe 1 avec l'atome A' remonté à sa racine et pour branches Phi- et Phi+, celles résultant de l'exécution récursive de la fonction RéordBDD avec pour. nouvelle liste vars la liste reste, respectivement aux branches Phi- et Phi+ du BDD Phi où A' est remplacé par F dans Phi- et par V dans Phi+.

L'annexe 10 décrit la fonction Bnégatives qui construit un ensembles d'atomes pour lesquels il existe une branche Phi- d'un BDD Phi, elle même BDD, aboutissant à F. L'ensemble est vide si le BDD Phi est V ou F. Un BDD Phi différent de F ou de V possède un atome xi à sa racine et deux BDD Phi- et Phi+. L'ensemble est égal à l'union, symbolisée U, des ensembles construits pour Phi- et Phi+ par exécution récursive de la fonction Bnégatives sur ces BDD, et du singleton contenant l'atome xi si le BDD Phi- est différent de V.

L'annexe 11 décrit la fonction Bpositives qui construit un ensembles d'atomes pour lesquels il existe une branche Phi+ d'un BDD Phi aboutissant à F. L'ensemble est vide si le BDD Phi est V ou F. Un BDD Phi différent de F ou de V possède un atome xi à sa racine et deux BDD Phi- et Phi+. L'ensemble est égal à l'union, symbolisée U, des ensembles construits pour Phi- et Phi+ par exécution récursive de la fonction Bpositives sur ces BDD, et du singleton contenant l'atome xi si le BDD Phi+ est différent de V.

L'annexe 12 décrit la fonction Complément qui construit un ensemble d'atomes complémentaires d'un atome A dans un BDD Phi. Les atomes complémentaires d'un atome A sont, par définition, les atomes pour lesquels il existe une branche Phi+ aboutissant à F lorsque A est remplacé par F et une branche Phi- aboutissant à F lorsque A est remplacé par V. L'ensemble des atomes complémentaires est donc l'union, symbolisée par U, des ensembles construits par les fonctions Bpositives et Bnégatives, pour le BDD Phi, où l'atome A est remplacé par F, respectivement par V.

Sur l'exemple que nous nous sommes donné, avec comme ordre, l'ordre d'écriture de la formule, c'est à dire P(a) < P(b) < P(x),

Phi = Choix (êta,Phi-,Phi+) avec êta=P(a).

L'unification de P(x) à P(a) donne la substitution minimale m.g.u. [a/x]. Ce qui revient à considérer P(x) et P(a) logiquement équivalents, la fonction de l'annexe 7 est lancée avec xi=P(a), xi'=P(x). On est dans le cas où êta=xi. Le résultat est alors:

Fait BDD (P(a), RempF(Phi-,P(x)), RempV(Phi+,P(x))).

Les fonctions RempF et RempV sont définies respectivement en annexe 5 et 6.

- En annexe 5, on est dans le cas où Phia-=Choix(P(b),Phi-,Phi+) avec P(b)<P(x), ce qui donne le résultat: FaitBDD (P(b), RempF(Phi-,P(x)), RempF(Phi+,P(x))). On voit sur la figure 1 que RempF(Phi-,P(x)) est dans le cas où Phi-=V, ce qui donne V, et que RempF(Phi+,P(x)) est dans le cas où Phi+=Choix(P(x),F,V) avec xi=xi'=P(x), ce qui donne F. Le résultat est donc:

  Fait BDD (P(b),V,F), c'est à dire, suivant l'annexe 1, Choix(P(b),V,F).

- En annexe 6, on est dans le cas où Phi=Choix(P(x),F,V) avec xi=xi'=P(x), ce qui donne le résultat Phi+, c'est à dire V.

Le résultat est donc:

Fait BDD (P(a), Choix(P(b),V,F), V), c'est à dire Choix (P(a), Choix(P(b),V,F), V). L'équivalence de P(x) à P(a) ne suffit donc pas à réduire Phi à V, il y a échec. En cas d'échec, intervient une procédure d'amplification. Cette procédure consiste à faire une disjonction du BDD pour lequel il y a eu échec avec une copie suplémentaire de ce BDD pour une nouvelle série de variables. Si Phi1 est le BDD précédent avec chaque variable x indicée x1, Phi2 est le BDD suplémentaire avec chaque variable x indicée x2.

Suivant l'annexe 4, BDD ou (Phi1, Phi2) est dans le cas où Phi1=Choix(P(a),Phi1a-,Phi1a+) et Phi2=Choix(P(a),Phi2a-,Phi2a+) avec xi=xi'=P(a). Ce qui donne, en corrélation. avec l'annexe 1, Choix(P(a), BDDou(Phi1a-, Phi2a-), BDDou(Phi1a+,Phi2a+)). Les appels récursifs successifs de la fonction BDDou donnent alors:

BDDou(Phi1a-,Phi2a-) = Choix(P(b), BDDou(Phi1b-,Phi2b-), BDDou(Phi1b+,Phi2b+)),

BDDou(Phi1a+,Phi2a+) = Choix(P(x1), BDDou(Phi1x1-,Phi2x2), BDDou(Phi1x1+,Phi2x2)),

BDDou(Phi1b-,Phi2b-) = V,

BDDou(Phi1b+,Phi2b+) = Choix(P(x1), BDDou(Phi1x1-,Phi2x2), BDDou(Phi1x1+,Phi2x2)),

BDDou(Phi1x1-,Phi2x2) = Phi2x2 = Choix(P(x2),F,V),

BDDou(Phi1x1+,Phi2x2) = V.

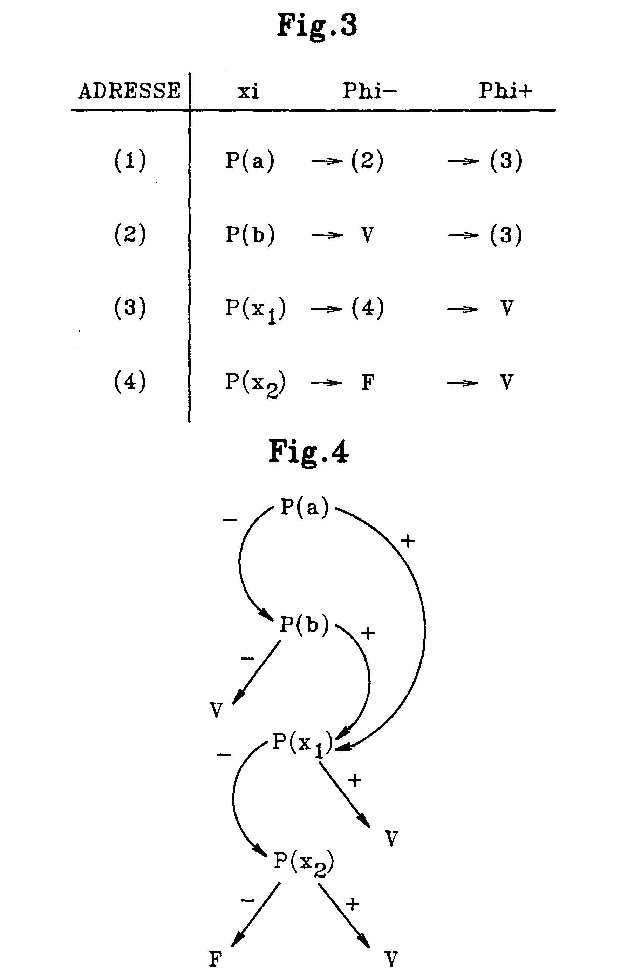

Les retours de récursivité donnent finalement les résultats stockés en mémoire d'ordinateur sous la forme du tableau de la figure 3 dont une représentation symbolique est donnée en figure 4.

Appliquons les fonctions des annexes 10 à 11 au BDD Phiex constitué de deux copies de la formule de départ.

```
Bnégatives (Phiex)
      Phiex = Choix(P(a),Phia-,Phia+)
      Bnégatives (Phia-)
            Phia- = Choix(P(b),V,Phib+)
            Bnégatives (Phib+)
                  Phib+ = Choix(P(x1),Phix1-,V)
                  Bnégatives (Phix1-)
                        Phix1- = Choix(P(x2),F,V)
                  :={P(x2)}
            := {P(x2),P(x1)}
      :={P(x2),P(x1)}
      Bnégatives (Phia+)
            Phia+ = Choix(P(x1),Phix1-,V)
                  Phix1- = Choix(P(x2),F,V)
            :={P(x2)}
      :={P(x2),P(x1)}
:={P(x2),P(x1),P(a)}


Bpositives (Phiex)
      Phiex = Choix(P(a),Phia-,Phia+)
      Bpositives (Phia-)
            Phia- = Choix(P(b),V,Phib+)
            Bpositives (Phib+)
                  Phib+ = Choix(P(x1),Phix1-,V)
                  Bpositives (Phix1-)
                        Phix1- = Choix(P(x2),F,V)
                  := {}
            := {}
      := {P(b)}
      Bpositives (Phia+)
            Phia+ = Choix(P(x1),Phix1-,V)
            Bpositives(Phix1-)
                  Phix1- = Choix(P(x2),F,V)
            :={}
      := {}
:= {P(b),P(a)}
```

Nous obtenons donc Bnégatives(Phiex)={P(x2),P(x1),P(a)} et Bpositives(Phiex)={P(b),P(a)}. Ce qui veut dire que les atomes P(x2),P(x1),P(a) sont négatifs, c'est à dire qu'il existe au moins une feuille F du BDD en remplaçant un de ces atomes par F. De même, les atomes P(b),P(a) sont positifs, c'est à dire qu'il existe au moins une feuille F du BDD en remplaçant un de ces atomes par V.

Pour déterminer les atomes complémentaires de P(a) dans Phiex, la fonction de l'annexe 12 est exécutée avec A=P(a) et Phi=Phiex.

RempF(Phiex, P(a))=Choix(P(b),V, Phib+),

RempV(Phiex,P(a))=Choix(P(x1), Phix1-,V).

En réutilisant les résultats précédents, Bpositives(Choix(P(b),V,Phib+)) = {P(b)} et Bnégatives(Choix(P(x1), Phix1-,V)) = {P(x2),P(x1)}. Finalement:

Complément (P(a),Phiex) = {P(b),P(x2),P(x1)}. Cet ensemble détermine les atomes complémentaires avec P(a) dans Phiex.

Suivant l'annexe 7, la fonction RéduitBDD donne les résultats suivants pour BDDou(Phi1,Phi2). L'ordre défini est maintenant P(a)<P(b)<P(x1)<P(x2).

La fonction de l'annexe 7 est lancée avec xi=P(a), xi'=P(x1). On est dans le cas où êta=xi. Le résultat est alors:

Fait BDD (P(a), RempF(Phia-,P(x1)), RempV(Phia+,P(x1))).

Les fonctions RempF et RempV sont définies respectivement en annexe 5 et 6.

- En annexe 5, on est dans le cas où Phia-=Choix(P(b),Phib-,Phib+) avec P(b)<P(x1), ce qui donne le résultat: FaitBDD (P(b), RempF(Phib-,P(x1)), RempF(Phib+,P(x1))). On voit sur la figure 1 que RempF(Phib-,P(x1)) est dans le cas où Phib-=V, ce qui donne V, et que RempF(Phib+,P(x1)) est dans le cas où Phib+=Choix(P(x1),Phix1-,V) avec xi=xi'=P(x1), ce qui donne Phix1-, c'est à dire Choix(P(x2),F,V). Le résultat est alors:
FaitBDD (P(b),V,Choix(P(x2),F,V)) = Choix(P(b),V,Choix(P(x2),F,V))
- En annexe 6, on est dans le cas où Phia+=Choix(P(x1),Phix1-,V) avec xi=xi'=P(x1), ce qui donne Phix1-, c'est à dire Choix(P(x2),F,V). Le résultat est donc:
Fait BDD (P(a), Choix(P(b),V,Choix(P(x2),F,V)), Choix(P(x2),F,V)), c'est à dire
Choix (P(a), Choix(P(b),V,Choix(P(x2),F,V)), Choix(P(x2),F,V)).

La fonction RéduitBDD (Phi,xi,xi') est ensuite exécutée avec xi=P(b) et xi'=P(x2).

êta=P(a)<P(b) donc

:= FaitBDD (P(a), RéduitBDD(Choix(P(b),V,Choix(P(x2),V,F)),P(b),P(x2)), RéduitBDD(Choix(P(b),V,Choix(P(x2),F,V)),P(b),P(x2)))

RéduitBDD(Choix(P(b),V,Choix(P(x2),F,V)),P(b),P(x2))

:= FaitBDD (P(b), RempF(V,P(x2)), RempV(Choix(P(x2),F,V),P(x2)))

:= FaitBDD (P(b),V, V)

:=V

RéduitBDD(Choix(P(b),V,Choix(P(x2),F,V)),P(b),P(x2)))

:= FaitBDD (P(b), RempF(V,P(x2)), RempV(Choix(P(x2),F,V),P(x2))

:= FaitBDD (P(b), V, V)

:=V

:= FaitBDD (P(a), V, V)

Le BDD est réduit à V. La preuve est obtenue. L'exemple de la figure 1 a permis de montrer le mécanisme de la preuve pour une formule Phiex à une variable. Avec plusieurs variables x, y, le problème est de déterminer quel atome P(x) ou P(y) prendre pour xi' de façon à obtenir la preuve le plus rapidement possible. De même, si dans Phiex, le choix de constantes P(a) ou P(b) pour xi est de peu d'importance dans l'obtention de la preuve grâce à la symétrie de leur occurrence, pour des BDD plus complexes, le problème est de déterminer quel atome P(a) ou P(b) prendre pour xi.

Un objet de l'invention est de choisir pour l'atome xi un atome C qui laissera le moins de choix possibles dans le BDD Phi pour les substitutions m.g.u. entre l'atome xi et les atomes complémentaires xi' avec l'atome xi dans le BDD Phi. Puis, parmi les substitutions m.g.u, explorer en priorité celles maximisant le gain d'information du BDD Phi résultant. Cet objet de l'invention sera mieux compris dans la suite de la description.

L'annexe 8 décrit la fonction bFbV qui permet de calculer un couple dont le premier élément est le nombre de branches fausses, aboutissant à F, d'un BDD Phi et dont le deuxième élément est le nombre de branches vraies, aboutissant à V, de ce même BDD Phi. Cette fonction est récursive car le nombre de branches fausses et le nombre de branches vraies d'un BDD Phi sont respectivement égaux à la somme des nombres de branches fausses des BDD Phi- et Phi+ et à la somme des nombres de branches vraies des BDD Phi- et Phi+. Ces nombres sont initialisés à (1,0) sur une feuille F et à (0,1) sur une feuille V.

L'annexe 13 décrit l'algorithme de la fonction de preuve pour une liste q de triplets (Phi,Phi',Sigma). A l'initialisation, q contient un seul triplet (Phi,Phi',Sigma) où Phi est le BDD de la formule à prouver. Phi étant le BDD d'une formule exprimant qu'une conjonction d'axiomes Ax implique une proposition Psi, Phi' est le BDD témoin de Phi défini comme le BDD de la conjonction des axiomes Ax et de la proposition Psi. Sigma est l'ensemble des substitutions d'atomes de Phi interdites. Au départ, Sigma est initialisé à l'ensemble vide. A ce triplet sont associés un gain d'information GI initialisé à zéro et une quantité d'information QI telle que, suivant l'annexe 8,

(bF,bV) := bFbV(Phi')
QI := bF log(bF/(bF+bV))

La fonction Preuve(q) est ensuite exécutée jusqu'à obtenir Echec qui signifie qu'aucune preuve ne peut être obtenue avec le nombre de copies de Phi ou à obtenir Prouvé qui signifie qu'il existe un nombre de copies fini de Phi pour que Phi soit juste.

Au point 1, si la liste q est vide, il n'y a pas de BDD Phi qui puisse être réduit à V, c'est l'échec de la preuve.

Au point 2, la liste q est ordonnée par ordre décroissant des gains d'information GI des triplets (Phi,Phi', Sigma). Cela résulte de la construction de q au point 7 sur laquelle nous reviendrons par la suite. La poursuite de la procédure de l'annexe 13 à partir du point 2 pour les triplets (Phi,Phi',Sigma) de q aborde les différentes branches d'un arbre de recherche, encore appelé arbre d'exécution, définies par chacun des triplets (Phi,Phi',Sigma). Extraire le premier triplet (Phi,Phi',Sigma) de la liste q revient donc à aborder la branche de cet arbre de recherche associée au gain maximal d'information GI. Ceci constitue une stratégie de parcours de l'arbre d'exécution par gain maximal d'information d'abord. Le triplet (Phi,Phi',Sigma) extrait de q sert à explorer la branche abordée suivant les points 3 à 8. Le triplet (Phi,Phi',Sigma) est enlevé de q pour permettre d'explorer la suite de l'arbre de recherche lors du retour sur le point 1 dicté par le point 8. Ces branches sont soit des branches parallèles à celle du triplet (Phi,Phi',Sigma) extrait, soit des branches filles du triplet (Phi,Phi',Sigma) construite, comme nous le verrons au point 7, suivant leur gain d'information GI. En effet, le premier triplet (Phi,Phi',Sigma) de la liste restante q sera celui de gain d'information GI maximal.

Au point 3, si le BDD témoin Phi' du triplet (Phi,Phi',Sigma) est égal à V, la formule est prouvée.

Au point 4, si le BDD témoin Phi' du triplet (Phi,Phi',Sigma) est égal à F, il n'existe pas de preuve pour le triplet choisi, il est nécessaire de revenir au point 1 pour essayer un autre triplet.

Au point 5, pour chaque atome A de Phi', sont calculés deux BDD Phi0 et Phi'0 par les fonctions des annexes 3 et 4, à partir des BDD Phi[V/A] où V est substitué à A dans Phi, Phi[F/A] où F est substitué à A dans Phi, Phi'[V/A] où V est substitué à A dans Phi', Phi'[F/A] où F est substitué à A dans Phi'.

Au point 6, un ensemble des atomes, complémentaires de A dans Phi', est construit à l'aide des fonctions des annexes 10 à 12. A partir de cet ensemble, est construit un ensemble DeltaSigma des substitutions minimales m. g.u en cherchant à unifier l'atome A avec chaque atome complémentaire suivant l'une des procédures d'unification connues dans l'état de la technique. Comme nous le verrons au point 7, chaque substitution $\sigma$ de l'ensemble DeltaSigma ajoute un triplet (Phi$\sigma$,Phi'$\sigma$,Sigma) à la liste q. Cet ajout augmente donc le nombre de branches filles résultant du choix d'un atome A, c'est à dire le non déterminisme, associé au choix d'un atome A, dans l'arbre d'exécution. En ne retenant que l'atome A pour lequel le nombre card(DeltaSigma), d'éléments de DeltaSigma, est le plus faible, le nombre de branches filles est minimisé. Ceci constitue une minimisation du non déterminisme.

Au point 7, pour chaque substitution $\sigma$ de DeltaSigma, sont calculés les BDD Phi $\sigma$ et Phi'$\sigma$ à l'aide de la fonction de l'annexe 7. Pour chaque substitution est alors créé un nouveau triplet (Phi$\sigma$,Phi'$\sigma$,Sigma) en utilisant l'ensemble Sigma du triplet (Phi,Phi',Sigma) extrait au point 2. Le gain d'information GI de chaque BDD Phi'$\sigma$ est calculé, comme pour tout BDD Phi, à l'aide de l'annexe 8, de la façon suivante.

QI(Phi') et GI(Phi') ayant été calculé lors de la création du triplet (Phi,Phi',Sigma) (bF,bV) := bFbV(Phi'$\sigma$)
QI(Phi'$\sigma$) := bF log( bF / (bF+bV))
GI(Phi'$\sigma$) := GI(Phi') + QI(Phi'$\sigma$) - QI(Phi') - log( card(DeltaSigma)+1)
GI(Phi'O) se calcule de façon identique en remplaçant Phi'$\sigma$ par Phi'O.

Le triplet (Phi0, Phi'0,Sigma U DeltaSigma) est créé où U réalise l'union des deux ensembles Sigma et DeltaSigma. Chaque triplet créé est inséré dans la liste q, à partir de la tête de celle-ci, devant le premier triplet de la liste q de gain GI inférieur à celui du triplet inséré.

Au point 8, la procédure est réitérée.

Annexe 1

Fonction FaitBDD (xi,Phi-,Phi+)

$\qquad$ Si Phi- = Phi+ $\qquad$ alors

:= Phi+

$\qquad$ Sinon $\qquad$ alors

:= Choix (xi,Phi-,Phi+)


Annexe 2

Fonction BDDneg (Phi)

$\qquad$ Si Phi= V $\qquad$ alors

:= F

$\qquad$ Si Phi= F $\qquad$ alors

:= V

$\qquad$ Si Phi= Choix(xi,Phi-,Phi+) $\qquad$ alors

:=Choix(xi,BDDneg (Phi-),BDDneg(Phi+))


Annexe 3

Fonction BDDet (Phi,Phi')

$\qquad$ Si Phi= F $\qquad$ alors

:= F

$\qquad$ Si Phi'= F $\qquad$ alors

:= F

$\qquad$ Si Phi= V $\qquad$ alors

:= Phi'

$\qquad$ Si Phi'= V $\qquad$ alors

:= Phi

$\qquad$ Si Phi=Choix(xi,Phi-,Phi+) et Phi'=Choix(xi',Phi'-,Phi'+)

$\qquad$ Si xi < xi' $\qquad$ alors

:= FaitBDD (xi, BDDet (Phi-,Phi'), BDDet (Phi+,Phi'))

$\qquad$ Si xi > xi' $\qquad$ alors

:= FaitBDD (xi', BDDet (Phi,Phi'-), BDDet (Phi,Phi'+))

$\qquad$ Sinon $\qquad$ alors

:= FaitBDD (xi, BDDet (Phi-,Phi'-), BDDet (Phi+,Phi'+))

## Annexe 4

```
Fonction BDDou (Phi,Phi')
            Si Phi=V                      alors
:= V
            Si Phi'=V                     alors
:= V
            Si Phi=F                      alors
:= Phi'
            Si Phi'=F                     alors
:= Phi
            Si Phi=Choix(xi,Phi-,Phi+) et Phi'=Choix(xi',Phi'-,Phi'+)
                    Si xi < xi'           alors
:= FaitBDD (xi, BDDou(Phi-,Phi'), BDDou(Phi+,Phi'))
                    Si xi > xi'           alors
:= FaitBDD (xi', BDDou(Phi,Phi'-), BDDou(Phi,Phi'+))
                    Sinon                 alors
:= FaitBDD (xi,  BDDou(Phi-,Phi'-), BDDou(Phi+,Phi'+))
```

## Annexe 5

```
Fonction RempF (Phi,xi')
            Si Phi=V                      alors
:= V
            Si Phi=F                      alors
:= F
            Si Phi=Choix(xi,Phi-,Phi+)
                    Si xi < xi'           alors
:= FaitBDD (xi, RempF(Phi-,xi'), RempF(Phi+,xi'))
                    Si xi = xi'           alors
:= Phi-
                    Sinon                 alors
:= Phi
```

## Annexe 6

Fonction RempV (Phi,xi')

Si Phi=V        alors

:= V

Si Phi=F        alors

:= F

Si Phi=Choix(xi,Phi-,Phi+)

Si xi < xi'        alors

:= FaitBDD (xi, RempV(Phi-,xi'), RempV(Phi+,xi'))

Si xi = xi'        alors

:= Phi+

Sinon        alors

:= Phi

## Annexe 7

Fonction RéduitBDD (Phi,xi,xi') avec xi<xi'

Si Phi=V        alors

:= V

Si Phi=F        alors

:= F

Si Phi=Choix(êta,Phi-,Phi+)

Si êta < xi        alors

:= FaitBDD (êta, RéduitBDD(Phi-,xi,xi'), RéduitBDD(Phi+,xi,xi'))

Si êta = xi        alors

:= FaitBDD (xi, RempF(Phi-,xi'), RempV(Phi+,xi'))

Sinon        alors

:= FaitBDD (xi, RempF(Phi,xi'), RempV(Phi,xi'))

Annexe 8.

Fonction bFbV (Phi)
      Si Phi = F               alors
:= (1,0)
      Si Phi = V               alors
:= (0,1)
      Si Phi = Choix(xi,Phi-,Phi+)     alors
:= bFbV (Phi-) + bFbV (Phi+)

Annexe 9

Fonction RéordBDD (Phi,vars)
      Si  Phi=V               alors
:= V
      Si  Phi=F               alors
:= F
      Si  Phi=Choix(A,Phi-,Phi+))
         Si vars=A::reste   alors
:= FaitBDD (A,RéordBDD(Phi-,reste),RéordBDD(Phi+,reste))
         Si vars=A'::reste   alors
:=               FaitBDD               (A',RéordBDD(RempF(Phi-
,A'),reste),RéordBDD(RempV(Phi+,A'),reste))

Annexe 10

Fonction Bnégatives (Phi)
        Si Phi=V
:= {}
        Si Phi=F
:= {}
        Si Phi=Choix(xi,Phi-,Phi+) alors
        si Phi-=V        alors
:= Bnégatives (Phi-) U Bnégatives (Phi+)
        sinon        alors
:= Bnégatives (Phi-) U Bnégatives (Phi+) U {xi}


Annexe 11
Fonction Bpositives (Phi)
        Si Phi=V
:= {}
        Si Phi=F
:= {}
        Si Phi=Choix(xi,Phi-,Phi+) alors
        si Phi+=V        alors
:= Bpositives (Phi-) U Bpositives (Phi+)
        sinon        alors
:= Bpositives (Phi-) U Bpositives (Phi+) U {xi}


Annexe 12

Fonction Complément (A,Phi)
:= Bpositives (RempF(Phi,A)) U Bnégatives (RempV(Phi,A))

## Annexe 13

Fonction Preuve(q)

    1. Si q = { }        alors

:= Echec.

    Sinon,

    2. extraire le premier triplet (Phi,Phi',Sigma) de la liste q et l'enlever de q,

    3. si Phi' = V        alors

:= Prouvé.

    4. Sinon, si Phi' = F alors

    revenir au point 1.

    5. Sinon, pour chaque atome A de Phi',

        calculer Phi0 := BDDet (Phi [V/A],Phi [F/A])

        calculer Phi'0 := BDDet (Phi0, BDDou(Phi'[V/A],Phi'[F/A])

        6. calculer l'ensemble DeltaSigma des m.g.u qui unifie A à un atome complémentaire dans Phi' et qui ne sont pas dans Sigma.

    retenir l'atome A et l'ensemble DeltaSigma pour lequel card.(DeltaSigma) est minimal,

    7. pour chaque $\sigma$ de DeltaSigma, calculer le triplet (Phi$\sigma$,Phi'$\sigma$,Sigma) et le gain d'information GI de Phi'$\sigma$,

    calculer le triplet (Phi0,Phi'0,Sigma U DeltaSigma) et le gain d'information GI de Phi'0,

    ajouter les triplets calculés à la liste q en triant cette liste par ordre de gain d'information GI décroissant,

    8. revenir au point 1.

### Revendications

**1.** Procédé de démonstration automatique de propositions décrivant des systèmes physiques, en logique du premier ordre, mis en oeuvre à l'aide d'un ordinateur dans la mémoire duquel une proposition à démontrer est représentée par au moins un diagramme de décision binaire BDD, **caractérisé en ce que** le procédé cherche à réduire le BDD à une constante (V), symbolisant le vrai, par au moins une substitution en construisant et en explorant un arbre de recherche des substitutions possibles, dont chaque noeud est associé à un BDD résultant d'une subtitution possible.

**2.** Procédé selon la revendication 1, **caractérisé en ce que**, l'arbre de recherche est construit en minimisant son facteur de branchement, et exploré en maximisant le gain d'information de chaque BDD résultant d'une substitution possible, calculé au noeud de l'arbre de recherche auquel est associé ledit BDD résultant d'une substitution possible.

**3.** Procédé selon la revendication 2, **caractérisé en ce que** le gain d'information est calculé à chaque noeud associé à un BDD Phi, comme la différence entre la quantité d'information QI(Phi) au noeud et la quantité d'information à la racine de l'arbre de recherche, de laquelle on retranche la somme des logarithmes de chaque nombre de successeurs immédiats d'un noeud sur la branche entre la racine et le noeud considéré, à l'inclusion de la racine et à l'exclusion du noeud considéré, où QI(Phi) = bF log( bF / (bF+bV)), bF étant le nombre de branches fausses du BDD Phi et bV étant le nombre de branches vraies du BDD Phi.

4. Procédé selon la revendication 2, **caractérisé en ce qu'**il est utilisé pour assurer la cohérence de systèmes informatiques.

5. Système informatique, **caractérisé en ce qu'**il comprend un ordinateur mettant en oeuvre un algorithme basé sur le procédé tel que revendiqué dans l'une quelconque des revendications précédentes.

6. Programme d'ordinateur comprenant des portions/moyens/instructions de code de programme pour l'exécution des étapes du procédé selon l'une des revendications 1 à 4, lorsque ledit programme est exécuté sur un ordinateur.

**Patentansprüche**

1. Verfahren zur automatischen Beweisen von physikalische Systeme beschreibenden Propositionen in einer Logik erster Ordnung, das mit Hilfe eines Rechners ausgeführt wird, in dessen Speicher eine zu beweisende Proposition durch wenigstens ein binäres Entscheidungsdiagramm BDD repräsentiert ist, **dadurch gekennzeichnet, daß** das Verfahren versucht, das BDD durch wenigstens eine Substitution auf eine Konstante V, die "wahr" symbolisiert, zu reduzieren, indem es einen Suchbaum der möglichen Substitutionen konstruiert und abfragt, wovon jeder Knoten einem BDD, das sich aus einer möglichen Substitution ergibt, zugeordnet ist.

2. Verfahren nach Anspruch 1, **dadurch gekennzeichnet, daß** der Suchbaum dadurch konstruiert wird, daß sein Verzweigungsfaktor minimal gemacht wird, und dadurch abgefragt wird, daß der Informationsgewinn jedes aus einer möglichen Substitution sich ergebenden BDD, der an demjenigen Knoten des Suchbaums berechnet wird, dem das aus einer möglichen Substitution sich ergebende BDD zugeordnet ist, maximal gemacht wird.

3. Verfahren nach Anspruch 2, **dadurch gekennzeichnet, daß** der Informationsgewinn an jedem Knoten, der einem BDD Phi zugeordnet ist, berechnet wird durch Bilden der Differenz zwischen der Informationsmenge QI(Phi) am Knoten und der Informationsmenge an der Wurzel des Suchbaums und durch Subtrahieren hiervon der Summe der Logarithmen jeder Anzahl unmittelbarer Nachfolger eines Knotens auf dem Zweig zwischen der Wurzel und dem betrachteten Knoten unter Einschluß der Wurzel und unter Ausschluß des betrachteten Knotens, wobei QI (Phi) = bF log(bF/(bF + bV)), wobei bF die Anzahl der falschen Zweige von BDD Phi ist und bV die Anzahl der wahren Zweige von BDD Phi ist.

4. Verfahren nach Anspruch 2, **dadurch gekennzeichnet, daß** es für die Sicherstellung der Kohärenz von Datenverarbeitungssystemen verwendet wird.

5. Datenverarbeitungssystem, **dadurch gekennzeichnet, daß** es einen Rechner umfaßt, der einen Algorithmus ausführt, der auf dem Verfahren wie in einem der vorhergehenden Ansprüche beansprucht basiert.

6. Rechnerprogramm, das Abschnitte/Mittel/Anweisungen eines Programmcodes zur Ausführung der Schritte des Verfahrens nach einem der Ansprüche 1 bis 4 umfaßt, wenn das Programm in einem Rechner ausgeführt wird.

**Claims**

1. Method for automatically proving propositions describing physical systems, in first-order logic, implemented by means of a computer in the memory of which a proposition to be proved is represented by at least one binary decision diagram BDD, **characterised in that** the method seeks to reduce the BDD to a constant (V) symbolising truth, by at least one substitution while constructing and exploring a search tree for possible substitutions, in which each node is associated with a BDD resulting from a possible substitution.

2. Method according to Claim 1, **characterised in that** the search tree is constructed by minimising its branching factor, and explored by maximising the information gain of each BDD resulting from a possible substitution, calculated at the node of the search tree with which said BDD, resulting from a possible substitution, is associated.

3. Method according to Claim 2, **characterised in that** the information gain is calculated at each node associated with a BDD Phi, as the difference between the quantity of information QI(Phi) at the node and the quantity of information at the root of the search tree, from which there is deducted the sum of the logarithms of each number of immediate successors of a node on the branch between the root and the node in question, including the root and excluding the node in question, where QI(Phi) = bF log (bF / (bF+bV)), bF being the number of false branches of the BDD Phi and bV being the number of true branches of the BDD Phi.

4. Method according to Claim 2, **characterised in that** it is used for ensuring the coherence of data processing systems.

5. Data processing system, **characterised in that** it comprises a computer implementing an algorithm based on the method as claimed in any one of the preceding claims.

6. Computer program comprising program code portions/means/ instructions for executing the steps of the method according to one of Claims 1 to 4, when said program is executed on a computer.

# Fig.1

# Fig.2

| ADRESSE | xi | Phi− | Phi+ |
|---------|------|--------|--------|
| (1) | P(a) | → (2) | → (3) |
| (2) | P(b) | → V | → (3) |
| (3) | P(x) | → F | → V |

# Fig.3

| ADRESSE | xi | Phi− | Phi+ |
|---|---|---|---|
| (1) | P(a) | → (2) | → (3) |
| (2) | P(b) | → V | → (3) |
| (3) | $P(x_1)$ | → (4) | → V |
| (4) | $P(x_2)$ | → F | → V |

# Fig.4